# EUROPEAN PATENT SPECIFICATION

(11) **EP 1 670 696 B1**
(45) Date of publication and mention of the grant of the patent: **28.08.2013**
(21) Application number: 04770072.9
(22) Date of filing: 24.09.2004
(51) Int. Cl.: B65D 81/24, B65D 81/26, B65D 81/20

(54) **CONTAINER DEVICE FOR AN ELECTRONIC DISPLAY DEVICE**
BEHÄLTEREINRICHTUNG FÜR EINE ELEKTRONISCHE ANZEIGEEINRICHTUNG
AGENCEMENT DE DISPOSITIF D'AFFICHAGE ET CONTENANT ASSOCIE

(30) Priority: 27.09.2003 GB 0322686
(43) Date of publication of application: 21.06.2006
(73) Proprietor: Creator Technology B.V., 4837 BN Breda (NL)
(72) Inventor: VAN RENS, Bas, J. E., Philips Int. P. & Standards, Redhill Surrey RH1 5HA (GB); GELINCK, Gerwin, H., Philips I. P. & Standards, Redhill Surrey RH1 5HA (GB); HUITEMA, Hjalmar, E. A., Philips I. P. & Stand., Redhill Surrey RH1 5HA (GB); DE LEEUW, Dagobert, M., Philips I. P. & Standards, Redhill Surrey RH1 5HA (GB); NIJMAN, Aloysius, J., Philips I. P. & Standards, Redhill Surrey RH1 5HA (GB)
(74) Representative: Goddar, Heinz J.
(86) International application number: PCT/IB2004/051846
(87) International publication number: WO 2005/031685

(56) References cited:
- EP-A- 0 949 850
- US-A- 5 228 567
- US-A- 5 234 105
- US-A- 5 593 482
- US-A- 5 709 065

## Description

The present invention relates to a container, according to the preamble of claim 1, for storing a display device comprising a component being degradable upon exposure to an environmental factor.

Nowadays, new types of display devices based on new materials are attracting a considerable amount of attention. Such new materials include organic semiconductor materials such as organic light emitting diodes (OLEDs) and organic transistors, organic polymer based flexible substrates, new electro-optical materials such as organic electrophoretic materials and so on. The attractive properties of such materials include their low weight, low cost and their ability to enable potential new application domains for display devices, e. g., flexible display devices, especially if the flexibility of the display device is high enough to allow the display device to be rolled-up without damaging it.

However, a fundamental complication of developing such devices is the sensitivity of the new materials to environmental factors such as light and oxygen and/or moisture in the air, which degrade those materials over time, causing a loss in performance of the display device.

In US patent US6592969 and EP 0 949 850 A1, this problem is tackled by attaching a protective element including a thin layer of glass to the display area of a display device having a flexible substrate to protect an electrically active organic layer from exposure to such environmental factors and increase the lifetime of the display device.

However, the addition of such a protective element has some unwanted consequences. For instance, the protective element has a restrictive influence on the flexibility of the display device, which is unwanted when trying to achieve a rollable display device. Furthermore, the addition of the protective element increases the complexity and the weight of the display device, which may also be unwanted.

A wrapping sheet for electronic parts is disclosed in United States Patent US 5,228,567. The wrapping sheet may be employed to envelop electronic parts, which may be kept in an airtight bag that is in turn packed into an outer box for storage or transport. The wrapping sheet may comprise pouchy portions en-closing a silica gel as a getter material. Such a container accords with the preamble of each of claims 1, 2 and 4.

A package used for keeping an electric circuit board in an airtight cavity for preventing it from oxidation during transport is disclosed in United States Patent US 5,234,105.

A filter material comprising a silica gel for covering the vent holes of a computer disk drive is described in US 5,593,482.

In view of the cited prior art, it is the objective of the present invention to provide a container for storing a display device that allows to extend the lifetime of the getter material.

In a first aspect of the present invention, this objective is achieved by providing a container for storing a display device comprising a component being degradable upon exposure to an environmental factor, the container comprising protective means for reducing the exposure of the component to the environmental factor, wherein the protective means comprises a getter material, the container is arranged to store the display device during an inactive period of the display device, the container comprises an opening for at least partially exposing the display device during an active period of the display device, and the container comprises a lid for closing the opening of the container. The container comprises a chamber comprising the getter material, and the chamber comprises a further lid, wherein the container comprises means for closing said further lid responsive to removing the lid from the opening.

In another aspect, the present invention relates to a container for storing a display device comprising a component being degradable upon exposure to an environmental factor, the container comprising protective means for reducing the exposure of the component to the environmental factor, wherein the protective means comprise a getter material, the container is arranged to store the display device during an inactive period of the display device, and the container comprises an opening for at least partially exposing the display device during inactive period of the display device. The container is arranged to store a flexible display device in a flexed state, wherein the getter material is integrated on a flexible foil, the flexible foil being arranged to cover a flex part of the flexible display device.

In a further aspect, the present invention relates to a container for storing a display device comprising a component being degradable upon exposure to an environmental factor, the container comprising protective means for reducing the exposure of the component to the environmental factor, wherein the protective means comprises a getter material. The container is arranged to store the display device during an inactive period of the display device, and the container comprises an opening for at least partially exposing the display device during an active period of the display device. The opening comprises an airtight seal, and the inside of the container has an internal pressure, wherein the container further comprises a valve for maintaining the internal pressure, the valve comprising the getter material.

The present invention is based on the recognition that display devices including degradable components, e. g. , organic materials, can be used as disposables because of their low manufacturing cost. It is foreseen that customer satisfaction is primarily influenced by the handling characteristics of the display device such as its weight and its flexibility in case of flexible display devices rather than its lifetime, as long as the lifetime can be prolonged to a certain extent. Since it is anticipated that such display devices will be in idle state for the majority of their lifespan, either during their shelf life or during the period of active use, the present invention protects such a display device from exposure to harmful environmental factors such as the exposure to air or light during those inactive periods. This has the advantage that a display device including degradable components is obtained with a substantially increased lifetime compared to unprotected display devices having such components, without for instance compromising the flexibility of a flexible display device, because the protective means are detached from the display device itself.

The protective means may comprise a light shielding material, the light shielding material covering at least a substantial part of the container, an inert gas, a getter material or combinations of these embodiments to protect the flexible display device from exposure to light, oxygen, moisture or combinations thereof. This is particularly advantageous to extend the shelf life of the display device having degradable components. This is an important advantage, because it is likely that such a display device will spend most of its life on the shelf.

Containers having protective means to protect items during their shelf life are known per se, e. g. , a canister containing air-sensitive chemicals under a nitrogen atmosphere.

The invention is described in more detail and by way of non-limiting examples with reference to the accompanying drawings, wherein:
Fig. 1 shows an exemplary display device arrangement, not forming a part of the present invention.
Figs. 2-4 show various embodiments of the display device arrangement of the present invention.

It should be understood that the Figures ,are merely schematic and are not drawn to scale. It should also be understood that the same reference numera Is are used throughout the Figures to indicate the same or similar parts.

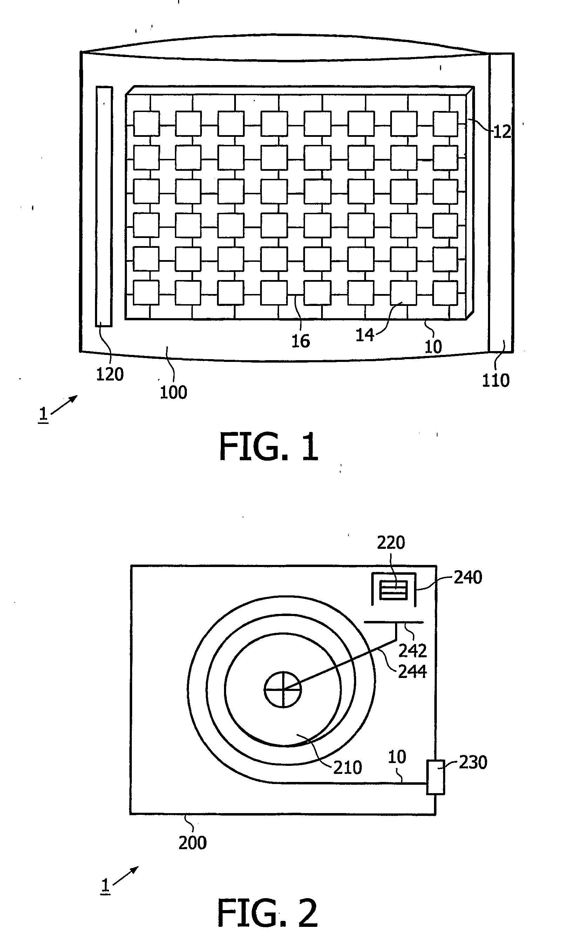

Fig.1 shows a display device arrangement 1 including a display device 10 stored in a container 100. The display device 10 typically includes a substrate 12, a plurality of pixels 14 and a plurality of electrodes 16 for connecting the pixels 14 to the appropriate driver circuitry. The substrate 12 may be a flexible substrate formed from an organic polymer or another suitable flexible material. In the case of an active matrix array display device, the pixels 14 may include a thin film transistor, which may include an organic semiconductor material. Again, this may be any known suitable organic semiconductor material, such as a polythiophene derivative or a polyphenylvinylene derivative. Typically, the pixels 14 include an electro-optical display element including an organic liquid crystal material, an organic semiconductor material like a light emitting organic polymer or an electrophoretic material, for example. The aforementioned organic materials are typical examples of components that are degradable upon exposure to an environmental factor such as light, air and moisture, i.e., components that undergo unwanted chemical reactions as a result of their exposure to such factors.

The container 100 protects the various degradable components of the display device 10 from exposure to environmental factors during the shelf life of the display device 10. In the embodiment shown in Fig. 1, the container 100 is a plastic bag having a seal 110. The plastic bag may be lined with a black out lining such as an aluminium foil to prevent exposure of the display device 10 to incident light. The container 100 may contain a getter material 120 to remove moisture from the atmosphere inside the container 100, e.g., the plastic bag, thus reducing the exposure of the flexible display device 10 to said moisture. The getter material 120 may comprise a silica gel or a hygroscopic salt such as sodium chloride. Such salts have been demonstrated to lower the relative humidity of the air inside the container 100 to around 10%. If even lower moisture levels are required, stronger hygroscopic materials such as sulphuric acid in an appropriate protective container may be used. The container 100 may also include an inert atmosphere such as nitrogen to protect the display device 10 from exposure to oxygen.

It will be obvious to those skilled in the art that the container 100 can come in many other forms. For instance, the container 100 may be a metal canister, a box with an airtight lid or any other suitable packaging.

At this stage, it is pointed out that in the claims, the protective means for reducing the exposure of the component to the environmental factor are to include protective means that exclude the exposure of the organic material to the environmental factor.

Figs. 2-4 show various embodiments of display device arrangements 1 that are intended to extend the active lifetime of the display device 10. In the Figs. 2-4, the display device 10 is depicted as a flexible display device. It is, however, emphasized that this is by way of non-limiting example only; non-flexible display devices having degradable components can also benefit from the protective measures depicted in those Figs and their accompanying detailed description.

In Fig. 2, the display device arrangement 1 includes a container 200, which has a spool 210 for storing the flexible display device 10 in a flexed state, e.g., a rolled-up state. The diameter of the spool 210 may be chosen in accordance with the flexibility of the flexible display device 10. The container 200, which may be formed from a light-shielding material, e.g., a suitable metal or plastic, is shown to have a rectangular shape, but it will be understood that other shapes such as a cylindrical shape, for instance, are equally feasible. The spool 210 typically is connected to a handle not shown outside the container 200 for to facilitate a user to store the display device 10. The container 200 has an opening with a fitting lid 230 through which the flexible display device 10 can be unrolled. The lid 230 is attached to an end of the flexible display device 10 to serve as a grip for facilitating the unrolling of the flexible display device 10.

The container 200 further includes a chamber 240 in which a getter material 220 is placed. The getter material 220 may be the same as the getter material 120. The chamber 240 has a further lid 242 attached to a lever 244, the lever 244 being attached to the spool 210. In the initial position of the spool 210, i.e., when the lid 230 is in place and the flexible display device 10 is stored, the further lid 242 is forced away from the chamber 240 by the lever 244, thus allowing contact between the getter material 220 and the internal atmosphere of the container 200. This reduces the exposure of the flexed display device 10 to moisture, which slows down the degradation of the degradable components of the flexible display device 10, thus prolonging its lifetime.

As soon as the spool 210 is forced from its initial position, i.e., as soon as the lid 230 is removed from the container 200 and the display device 10 is unrolled, the lever 244 will press the further lid 242 against the opening of the chamber 240, and the getter material 220 will be protected from the incoming air through the opening of the container 200. This extends the lifetime of the getter material 220.

It will be obvious that many alternatives of the embodiment shown in Fig. 2 can be thought of. For instance, the inside of the container may be fitted with a light sensor coupled to small electromotor, which is attached to the further lid 242 and closes the further lid 242 as soon as incident light through the opening of the container 200 is detected. Alternatively, the lid 230 may be fitted with a protruding feature that pushes the further lid 242 away from the chamber 240 upon inserting the lid 230 in the opening of the container 200. The lid 242 may also be omitted if the opening of the container 200 only allows small amounts of air to penetrate the container 200. This can for instance be realized by fitting an airtight seal such as a D-ring around the edges of the opening of the container 200. Also, in case of a non-flexible display device, it will be obvious that the spool 210 can be omitted.

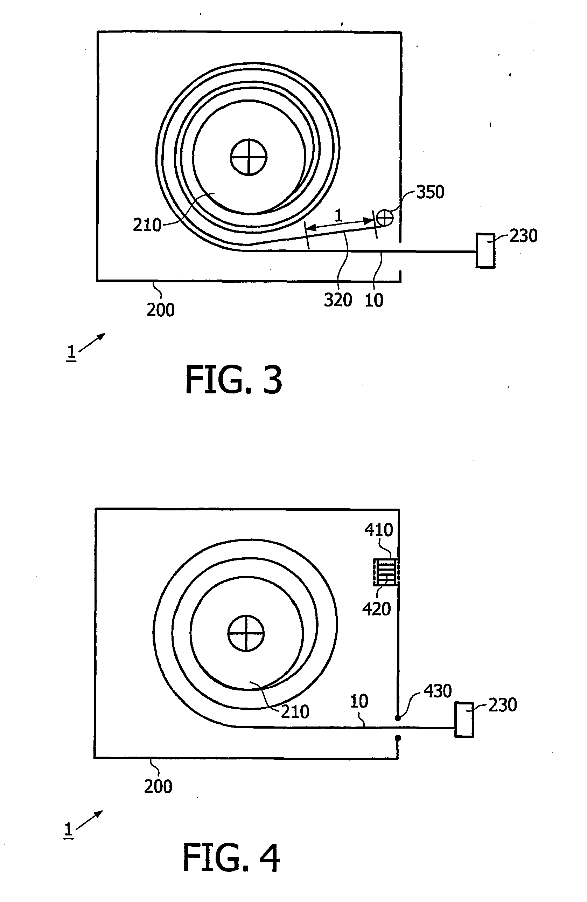

Fig. 3 shows an alternative embodiment of the display device arrangement 1 for extending the active lifetime of the flexible display device 10. In this embodiment, the getter material is integrated on a flexible foil 320. One end of the flexible foil 320 is attached to the spool 210, whereas the other end of the flexible foil 320 is attached to a further spool 350, which is coupled to the winding mechanism of the spool 210 to ensure synchronous rotation of both spools 210 and 350. In a totally unrolled state of the flexible display device 10, the flexible foil 320 will mainly reside on the further spool 350 in a rolled-up state. Upon rolling up the flexible display device 10, the flexible foil 320 will be unrolled from the further spool 350, and will be rolled-up onto the spool 210 together with the flexible display device 10 in such a way that a side of the flexible foil 320 carrying the getter material will be in close contact with the surface of the flexible display device 10 that is most degradable upon exposure to moisture, thus reducing the exposure of the flexible display device 10 to moisture in its flexed state. Typically, this surface is the surface of the flexible display device 10 carrying the pixels 14.

Because the flexible foil 320 is rolled-up onto the further spool 350 upon unrolling the flexible display device 10, the exposure of the getter material on the flexible foil 320 to the moisture is mainly limited to the length I shown in Fig. 3, thus protecting the bulk of the getter material from rapid saturation with moisture.

An embodiment of the flexible foil 320 may be produced in the following manner. As a material for the flexible foil, polydimethylsiloxane (PDMS) may be chosen, e.g., Sylgard 184 from the Du Pont chemical company. One equivalent of Sylgard cure is mixed with 10 equivalents of Sylgard base. Subsequently, crystals of a hygroscopic salt, e.g., sodium chloride crystals, are dispersed over a large area, e.g., the bottom of a large container. The Sylgard mixture is poured over and mixed with the salt crystals, thus dispersing the salt crystals through the Sylgard mixture. The mixture is heated at 65 °C overnight to polymerize the mixture and form a PDMS foil with integrated getter material. Optionally, prior to the polymerization step, the mixture may be degassed in an evacuated descicator to reduce the amount of air bubbles in the mixture.

The type of salt determines the relative humidity that will be established in an enclosed environment. A non-exhaustive list of salts and their equilibrium relative humidities can for instance be found in the handbook of chemistry and physics, 64th edition, CRC press, Boca Raton.

Another embodiment of a display device arrangement 1 for extending the active lifetime of the flexible display device 10 is shown in Fig. 4.

The opening of the container 200 is fitted with an air-tight seal 430, e.g., a d-ring, to maintain an internal pressure in the container 400 by preventing the influx of air into the container 200 through its opening. In addition, the container 200 has a valve 410 containing a getter material 420, the valve 410 connecting the inside of the container 200 with the outside world. The getter materials 420 may be any suitable getter material including the materials mentioned as embodiments for the getter material 120. The container 200 may be initially filled with an inert gas like nitrogen to protect the organic semiconductor materials on the flexible display device 10.

Upon unrolling of the flexible display device 10 through the opening of the container 200, the internal pressure of the container will drop due to reduction of the volume of the flexible display device 10 that resides inside the container 200. Consequently, air will start flowing into the container 200 through the valve 410 to compensate for the drop in internal pressure. The incoming air has to pass through the getter material 420, thus reducing the amount of moisture in the incoming air. As a result, the flexible display device 10 will benefit from a reduced exposure to moisture in its rolled-up state, thus increasing its lifetime.

It is emphasized that the container 200 shown in Fig. 2-4 for storing a display device 10 can be produced and sold separately with the various embodiments of the protective means integrated in the containers to facilitate the intended protection of a display device 10 having components that are degradable upon exposure to an environmental factor.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A container ( 200) for storing a display device (10) comprising a component being degradable upon exposure to an environmental factor; the container (200) comprising protective means for reducing the exposure of the component to the environmental factor, wherein:
the protective means comprises a getter material (220);
the container (200) is arranged to store the display device (10) during an inactive period of the display device (10);
the container (200) comprises an opening for at least partially exposing the display device (10) during an active period of the display device (10); **characterized in that** the container (200) comprises a lid (230) for closing the opening of the container (200);
and
the container (200) comprises a chamber (240) containing the getter material (220); said chamber (240) comprising a further lid (242); and said container (200) comprising means (244) for closing the further lid (242) responsive to removing the lid (230) from the opening of the container (200).

2. A container (200) for storing a display device (10) comprising a component being degradable upon exposure to an environmental factor; the container (200) comprising protective means for reducing the exposure of the component to the environmental factor;
wherein:
the protective means comprises a getter material (320);
the container (200) is arranged to store the display device (10) during an inactive period of the display device (10); and
the container (200) comprises an opening for at least partially exposing the display device (10) during an active period of the display device (10);
**characterized in that** the container (200) is arranged to store a flexible display device (10) in a flexed state;
wherein the getter material is integrated on a flexible foil (320), the flexible foil (320) being arranged to cover a flexed part of the stored flexible display device (10).

3. The container (200) according to claim 2, wherein the flexible foil (320) comprises polydimethylsiloxane.

4. A container (200) for storing a display device (10) comprising a component being degradable upon exposure to an environmental factor; the container (200) comprising protective means for reducing the exposure of the component to the environmental factor,
wherein the protective means comprises a getter material (420);
the container (200) is arranged to store the display device (10) during an inactive period of the display device (10);
the container (200) comprises an opening for at least partially exposing the display device (10) during an active period of the display device (10); **characterized in that** the opening comprises an airtight seal (430); and
**in that** the inside of the container (200) has an internal pressure; and
the container (200) further comprises a valve (410) for maintaining the internal pressure, the valve containing the getter material (420).

5. The container (200) according to any of the preceding claims, wherein the protective means comprises a light shielding material, the light shielding material covering at least a substantial part of the container (200).

6. The container (200) according to any of the preceding claims, wherein the protective means further comprises initially filling the container with an inert gas.

7. The container (200) according to any of the preceding claims, further comprising said display device (10) stored therein.

## Patentansprüche

1. Behälter (200) zum Aufnehmen einer Anzeigevorrichtung (10), welche eine Komponente enthält, die unter der Einwirkung von Umwelteinflüssen zersetzbar ist, wobei der Behälter (200) Schutzmittel umfasst, um das Einwirken der Umwelteinflüsse auf die Komponente zu reduzieren, wobei:
die Schutzmittel ein Gettermaterial (220) umfassen;
der Behälter (200) dazu eingerichtet ist, die Anzeigevorrichtung (10) während einer inaktiven Periode der Anzeigevorrichtung (10) aufzunehmen;
der Behälter (200) eine Öffnung aufweist, welche die Anzeigevorrichtung (10) während einer aktiven Periode der Anzeigevorrichtung (10) wenigstens teilweise freigibt;
**dadurch gekennzeichnet, dass** der Behälter (200) eine Abdeckung (230) zum Schließen der Öffnung des Behälters (200) umfasst;
der Behälter (200) eine Kammer (240) umfasst, welche das Gettermaterial (220) enthält;
wobei die Kammer (240) eine weitere Abdeckung (242) umfasst; und
der Behälter (200) Mittel (244) zum Schließen der weiteren Abdeckung (242) in Reaktion auf das Entfernen der Abdeckung (230) von der Öffnung des Behälters (200) umfasst.

2. Behälter (200) zum Aufnehmen einer Anzeigevorrichtung (10), welche eine Komponente enthält, die unter der Einwirkung von Umwelteinflüssen zersetzbar ist, wobei der Behälter (200) Schutzmittel umfasst, um das Einwirken der Umwelteinflüsse auf die Komponente zu reduzieren, wobei:
die Schutzmittel ein Gettermaterial (220) umfassen;
der Behälter (200) dazu eingerichtet ist, die Anzeigevorrichtung (10) während einer inaktiven Periode der Anzeigevorrichtung (10) aufzunehmen;
der Behälter (200) eine Öffnung aufweist, welche die Anzeigevorrichtung (10) während einer aktiven Periode der Anzeigevorrichtung (10) wenigstens teilweise freigibt;
**dadurch gekennzeichnet, dass** der Behälter (200) dazu eingerichtet ist, eine biegbare Anzeigevorrichtung (10) in einem gebogenen Zustand aufzunehmen;
wobei das Gettermaterial auf einer biegbaren Folie (320) integriert ist und die biegbare Folie (320) dazu eingerichtet ist, einen gebogenen Teil der aufgenommenen biegbaren Anzeigevorrichtung (10) zu bedecken.

3. Behälter (200) nach Anspruch 2, bei welchem die biegbare Folie (320) Polydimethylsiloxan umfasst.

4. Behälter (200) zum Aufnehmen einer Anzeigevorrichtung (10), welche eine Komponente enthält, die unter der Einwirkung von Umwelteinflüssen zersetzbar ist, wobei der Behälter (200) Schutzmittel umfasst, um das Einwirken der Umwelteinflüsse auf die Komponente zu reduzieren, wobei:
die Schutzmittel ein Gettermaterial (220) umfassen;
der Behälter (200) dazu eingerichtet ist, die Anzeigevorrichtung (10) während einer inaktiven Periode der Anzeigevorrichtung (10) aufzunehmen;
der Behälter (200) eine Öffnung aufweist, welche die Anzeigevorrichtung (10) während einer aktiven Periode der Anzeigevorrichtung (10) wenigstens teilweise freigibt;
**dadurch gekennzeichnet, dass** die Öffnung eine luftdichte Abdichteinrichtung (430) umfasst; und
das Innere des Behälters (200) einen Innendruck aufweist; und
der Behälter (200) ferner ein Ventil (410) zum Aufrechterhalten des Innendrucks umfasst,
wobei das Ventil das Gettermaterial (420) enthält.

5. Behälter (200) nach einem der vorangehenden Ansprüche, bei welchem das Schutzmittel ein Lichtabschirmmaterial umfasst, wobei das Lichtabschirmmaterial wenigstens einen wesentlichen Teil des Behälters (200) bedeckt.

6. Behälter (200) nach einem der vorangehenden Ansprüche, bei welchem das Schutzmittel ferner ein anfänglich den Behälter (200) füllendes Inertgas umfasst.

7. Behälter (200) nach einem der vorangehenden Ansprüche, in welchen die Anzeigevorrichtung (10) aufgenommen ist.

## Revendications

1. Contenant (200) destiné à renfermer un dispositif d'affichage (10) comportant un composant en mesure de se dégrader lors d'une exposition à un facteur environnemental ; le contenant (200) comportant un moyen de protection permettant de réduire l'exposition du composant au facteur environnemental, dans lequel :
le moyen de protection comporte un matériau dégazeur (220) ;
le contenant (200) est agencé pour renfermer le dispositif d'affichage (10) lors d'une période inactive du dispositif d'affichage (10) ;
le contenant (200) comporte une ouverture pour exposer au moins partiellement le dispositif d'affichage (10) lors d'une période active du dispositif d'affichage (10) ;
**caractérisé en ce que** le contenant (200) comporte un couvercle (230) permettant de fermer l'ouverture du contenant (200) ; et
le contenant (200) comporte une chambre (240) contenant le matériau dégazeur (220) ;
ladite chambre (240) comportant un autre couvercle (242) ; et
ledit contenant (200) comportant un moyen (244) permettant de fermer l'autre couvercle (242) en réponse au retrait du couvercle (230) de l'ouverture du contenant (200).

2. Contenant (200) destiné à renfermer un dispositif d'affichage (10) comportant un composant en mesure de se dégrader lors d'une exposition à un facteur environnemental ; le contenant (200) comportant un moyen de protection permettant de réduire l'exposition du composant au facteur environnemental ;
dans lequel :
le moyen de protection comporte un matériau dégazeur (320) ;
le contenant (200) est agencé pour renfermer le dispositif d'affichage (10) lors d'une période inactive du dispositif d'affichage (10) ; et
le contenant (200) comporte une ouverture pour exposer au moins partiellement le dispositif d'affichage (10) lors d'une période active du dispositif d'affichage (10) ;
**caractérisé en ce que** le contenant (200) est agencé pour renfermer un dispositif d'affichage flexible (10) dans un état fléchi ;
dans lequel le matériau dégazeur est intégré sur une feuille flexible (320), la feuille flexible (320) étant agencée pour couvrir une partie fléchie du dispositif d'affichage flexible renfermé (10).

3. Contenant (200) selon la revendication 2, dans lequel la feuille flexible (320) comporte du polydiméthylsiloxane.

4. Contenant (200) destiné à renfermer un dispositif d'affichage (10) comportant un composant en mesure de se dégrader lors d'une exposition à un facteur environnemental ; le contenant (200) comportant un moyen de protection permettant de réduire l'exposition du composant au facteur environnemental,
dans lequel le moyen de protection comporte un matériau dégazeur (420) ;
le contenant (200) est agencé pour renfermer le dispositif d'affichage (10) lors d'une période inactive du dispositif d'affichage (10) ;
le contenant (200) comporte une ouverture pour exposer au moins partiellement le dispositif d'affichage (10) lors d'une période active du dispositif d'affichage (10) ; **caractérisé en ce que** l'ouverture comporte un joint d'étanchéité étanche (430) ; et
**en ce que** l'intérieur du contenant (200) a une pression interne ; et
le contenant (200) comporte par ailleurs une valve (410) permettant de maintenir la pression interne, la valve contenant le matériau dégazeur (420).

5. Contenant (200) selon l'une quelconque des revendications précédentes, dans lequel le moyen de protection comporte un matériau pare-lumière, le matériau pare-lumière couvrant au moins une partie considérable du contenant (200).

6. Contenant (200) selon l'une quelconque des revendications précédentes, dans lequel le moyen de protection comporte par ailleurs le remplissage initial du contenant par du gaz inerte.

7. Contenant (200) selon l'une quelconque des revendications précédentes, comportant par ailleurs ledit dispositif d'affichage (10) renfermé dans celui-ci.
